# EUROPEAN PATENT APPLICATION

(11) **EP 1 909 311 A2**
(43) Date of publication of application: **09.04.2008**
(21) Application number: 07117808.1
(22) Date of filing: 03.10.2007
(51) Int. Cl.: H01L 21/28, H01L 29/423

(54) **Charge trap memory device**

(30) Priority: 04.10.2006 KR 20060097666
(71) Applicant: Samsung Electronics Co., Ltd., Suwon-si Gyeonggi-do 443-742 (KR)
(72) Inventor: Shin, Sang-min Samsung Advanced Institute of Technology, Gyeonggi-do (KR); Seol, Kwang-soo Samsung Advanced Institute of Technology, Gyeonggi-do (KR); Park, Sang-jin Samsung Advanced institute of Technology, Gyeonggi-do (KR); Sung, Jung-hun Samsung Advanced Institute of Technology, Gyeonggi-do (KR); Choi, Sang-moo Samsung Advanced Institute of Technology, Gyeonggi-do (KR)
(74) Representative: Greene, Simon Kenneth

(57) **Abstract**

A charge trap memory device may include a tunnel insulating layer formed on a substrate. A charge trap layer may be formed on the tunnel insulating layer, wherein the charge trap layer is a higher-k dielectric insulating layer doped with one or more transition metals. The tunneling insulating layer may be relatively non-reactive with respect to metals in the charge trap layer. The tunneling insulating layer may also reduce or prevent metals in the charge trap layer from diffusing into the substrate.

## Description

### BACKGROUND OF THE INVENTION

Example embodiments relate to a semiconductor memory device, e.g., a charge trap memory device.

A non-volatile memory device is a storage device that may maintain previously stored data after power to the device has been turned off. The memory cell structure constituting the non-volatile memory device may vary depending on the field of use. A NAND type flash semiconductor memory device is an example of a higher capacity non-volatile semiconductor memory device, wherein a gate structure of a transistor therein may include a sequentially stacked floating gate and control gate. Charges (e.g., data) may be stored in the floating gate, and the control gate may control the floating gate.

To increase memory capacity, the size of the memory cells in the flash semiconductor memory device may be reduced. Consequently, it may be beneficial to also reduce the height of the floating gate in response to the reduced size of the memory cells. To improve memory characteristics, a semiconductor memory device may have a silicon-oxide-nitride-oxide-semiconductor (SONOS) structure or a metal-oxide-insulator-oxide-semiconductor (MOIOS) structure so as to allow stored data to be safely maintained (e.g., in case of a leakage current) for a relatively long period of time. A SONOS structure or a MOIOS structure (e.g., a metal-oxide-nitride-oxide-semiconductor (MONOS) structure) may include a silicon nitride (Si₃N₄) layer instead of a floating gate for storing charges. The control gate of the SONOS memory device may be made of silicon, and the control gate of the MONOS memory device may be made of metal.

A MOIOS memory device may use a charge trap layer (e.g., silicon nitride layer (Si₃N₄)) instead of a floating gate for storing charges. For example, the MOIOS memory device may include an oxide-nitride-oxide (ONO) stack, wherein an oxide layer, a nitride layer, and an oxide layer are sequentially stacked, instead of a stack including a floating gate with insulating layers formed on and under the floating gate and disposed between a substrate and a control gate. In the MOIOS memory device, charges may be trapped in the nitride layer, thus shifting the threshold voltage.

A conventional SONOS memory device may include a first silicon oxide layer (SiO₂) formed as a tunnel insulating layer such that both ends of the silicon oxide layer contact the source and drain regions on a channel region of a semiconductor substrate. The first silicon oxide layer may be for tunneling charges. A silicon nitride (Si₃N₄) layer may be formed on the first silicon oxide layer as a charge trap layer. Data may be stored in the silicon nitride layer, and charges that have tunneled through the first silicon oxide layer may be trapped in the silicon nitride layer. A second silicon oxide layer may be formed on the silicon nitride layer as a blocking insulating layer so as to block upward-moving charges that pass through the silicon nitride layer. A gate electrode may be formed on the second silicon oxide layer.

However, a conventional SONOS memory device may have shortcomings in that the permittivities of the silicon nitride layer and the silicon oxide layers may be lower. The density of the trap site in the silicon nitride layer may also be insufficient, thus resulting in higher operation voltage. Additionally, the data recording speed (programming speed) and the charge retention time in vertical and horizontal directions may be less than desired.

Programming speed and retention characteristics may be improved by using an aluminum oxide (Al₂O₃) layer, instead of a silicon oxide layer, as the blocking insulating layer. However, although the blocking insulating layer formed of an aluminum oxide layer may increase the retention of charges in the silicon nitride layer, the trap site density of the silicon nitride layer itself may still be insufficient, thus limiting the overall improvement to the retention characteristic.

### SUMMARY OF EXAMPLE EMBODIMENTS

A charge trap memory device according to example embodiments may have improved retention characteristics compared to a conventional silicon-oxide-nitride-oxide-semiconductor (SONOS) memory device. The charge trap memory device may have more stable charge traps in a band gap of a charge trap material, wherein charges are trapped in the charge traps. For example, a charge trap memory device may include a tunnel insulating layer on a substrate and a charge trap layer on the tunnel insulating layer, wherein the charge trap layer is a higher-k dielectric insulating layer doped with one or more transition metals. The tunnel insulating layer may be relatively non-reactive with regard to metals (e.g., transition metals) in the charge trap layer. The tunnel insulating layer may also impede the diffusion of metals (e.g., transition metals) in the charge trap layer into the substrate.

The higher-k dielectric insulating layer may be formed of a compound selected from the group consisting of SiO₂, HfO₂, ZrO₂, Si₃N₄, Al₂O₃, HfSiON, HfON, and HfAlO. The transition metal may have a valence electron in a d-orbital. For example, the higher-k dielectric insulating layer may be a HfO₂ layer, and the one or more transition metals doped in the higher-k dielectric insulating layer may be at least one transition metal selected from the group consisting of tantalum (Ta), vanadium (V), ruthenium (Ru), and niobium (Nb). The higher-k dielectric insulating layer may also be a Al₂O₃ layer, and the one or more transition metals doped in the higher-k dielectric insulating layer may be at least one transition metal selected from the group consisting of tungsten (W), ruthenium (Ru), molybdenum (Mo), nickel (Ni), niobium (Nb), vanadium (V), and titanium (Ti). The one or more transition metals may be doped to a concentration of about 0.01 - 15 % (atomic %). Doping the higher-k dielectric insulating layer with at least two different transition metals may be beneficial in that electron traps and hole traps may be simultaneously formed in the higher-k dielectric insulating layer.

The tunnel insulating layer may be a silicon nitride layer. Alternatively, the tunnel insulating layer may have a two-layered structure including a silicon nitride layer and a silicon oxide layer. The silicon oxide layer, the silicon nitride layer, and the charge trap layer may be sequentially stacked on the substrate. The charge trap memory device may further include a blocking insulating layer on the charge trap layer and a gate electrode on the blocking insulating layer.

### BRIEF DESCRIPTION OF THE DRAWINGS

FIG. 1 is a schematic view of a charge trap non-volatile memory device according to example embodiments.

FIG. 2 is a schematic view of another charge trap non-volatile memory device according to example embodiments.

FIG. 3 is a transmission electron microscopy (TEM) photograph showing a cross-section of a silicon nitride layer and a higher-k dielectric insulating layer.

FIG. 4 is an XPS depth profile showing that a metal-silicon bond is not present at an interface between the silicon nitride layer and the higher-k dielectric layer of FIG. 3.

FIG. 5 shows the higher temperature retention characteristic obtained in a gate stack capacitor when a silicon nitride layer is used as a tunnel insulating layer.

FIG. 6 shows the higher temperature retention characteristic obtained in a gate stack capacitor when a silicon oxide layer is used as a tunnel insulating layer.

### DETAILED DESCRIPTION OF EXAMPLE EMBODIMENTS

It will be understood that when an element or layer is referred to as being "on", "connected to", "coupled to", or "covering" another element or layer, it may be directly on, connected to, coupled to, or covering the other element or layer or intervening elements or layers may be present. In contrast, when an element is referred to as being "directly on," "directly connected to" or "directly coupled to" another element or layer, there are no intervening elements or layers present. Like numbers refer to like elements throughout. As used herein, the term "and/or" includes any and all combinations of one or more of the associated listed items.

It will be understood that, although the terms first, second, third, etc. may be used herein to describe various elements, components, regions, layers and/or sections, these elements, components, regions, layers and/or sections should not be limited by these terms. These terms are only used to distinguish one element, component, region, layer or section from another region, layer or section. Thus, a first element, component, region, layer or section discussed below could be termed a second element, component, region, layer or section without departing from the teachings of example embodiments.

Spatially relative terms, e.g., "beneath," "below," "lower," "above," "upper" and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the exemplary term "below" may encompass both an orientation of above and below. The device may be otherwise oriented (rotated 90 degrees or at other orientations) and the spatially relative descriptors used herein interpreted accordingly.

The terminology used herein is for the purpose of describing various embodiments only and is not intended to be limiting of example embodiments. As used herein, the singular forms "a," "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

Example embodiments are described herein with reference to cross-sectional illustrations that are schematic illustrations of idealized embodiments (and intermediate structures) of example embodiments. As such, variations from the shapes of the illustrations as a result, for example, of manufacturing techniques and/or tolerances, are to be expected. Thus, example embodiments should not be construed as limited to the shapes of regions illustrated herein but are to include deviations in shapes that result, for example, from manufacturing. For example, an implanted region illustrated as a rectangle will, typically, have rounded or curved features and/or a gradient of implant concentration at its edges rather than a binary change from implanted to non-implanted region. Likewise, a buried region formed by implantation may result in some implantation in the region between the buried region and the surface through which the implantation takes place. Thus, the regions illustrated in the figures are schematic in nature and their shapes are not intended to illustrate the actual shape of a region of a device and are not intended to limit the scope of example embodiments.

Unless otherwise defined, all terms (including technical and scientific terms) used herein have the same meaning as commonly understood by one of ordinary skill in the art to which example embodiments belong. It will be further understood that terms, including those defined in commonly used dictionaries, should be interpreted as having a meaning that is consistent with their meaning in the context of the relevant art and will not be interpreted in an idealized or overly formal sense unless expressly so defined herein.

A charge trap layer of a non-volatile semiconductor memory device according to example embodiments may be a higher-k dielectric insulating layer having a permittivity of about 10 or more. One or more transition metals (e.g., a metal having a valence electron in a d-orbital) may be doped in the higher-k dielectric insulating layer to form a more stable charge trap that may be defined relatively distinctively in the band gap of the higher-k dielectric insulating layer. The charge trap may be a deeper trap that is more stable with regard to thermal excitation.

A deeper trap may have a larger energy gap between a valence band and a conduction band, such that electrons or holes in the deeper trap may not be easily excited by thermal excitation to the valence band or the conduction band. In contrast, a shallow trap may have a relatively low energy gap between the valence band and the conduction band, such that electrons or holes in the shallow trap may be easily excited by thermal excitation and contribute to electrical conduction.

The energy level of the deeper trap may be controlled by the type of transition metal used for doping. Additionally, the distribution of the energy level may be relatively discrete. Consequently, charges caught in the trap by a properly selected transition metal may be less likely to become thermally excited. Because trapped charges in a deeper trap may not be easily excited, the retention characteristics of a memory device may be improved.

The deeper trap may be formed in the higher-k dielectric insulating layer. The higher-k dielectric insulating layer may have a higher permittivity and, thus, may have more charge traps than a silicon nitride layer used as a conventional charge trap layer at the same equivalence of thickness (EOT). Also, the higher-k dielectric insulating layer may be better crystallized as opposed to a silicon nitride layer which may be amorphous. Thus, the trap in the higher-k dielectric insulating layer may have improved stability.

The retention characteristic of a non-volatile semiconductor memory device may be improved by increasing the trap site density of the charge trap layer and the thermal stability of the trap. When a higher-k dielectric insulating layer doped with transition metal is used as a charge trap layer, a silicon oxide layer used as a conventional tunnel insulating layer below the charge trap layer may react with a metal (e.g., transition metal) in the charge trap layer and form a metal-silicon compound. Additionally, a metal (e.g., transition metal) in the charge trap layer may diffuse into a silicon channel region of the substrate. To prevent these phenomena, the tunnel insulating layer may include a silicon nitride layer, thereby preventing the reaction of a metal in the charge trap layer with the tunnel insulating layer or diffusion of the metal into the substrate.

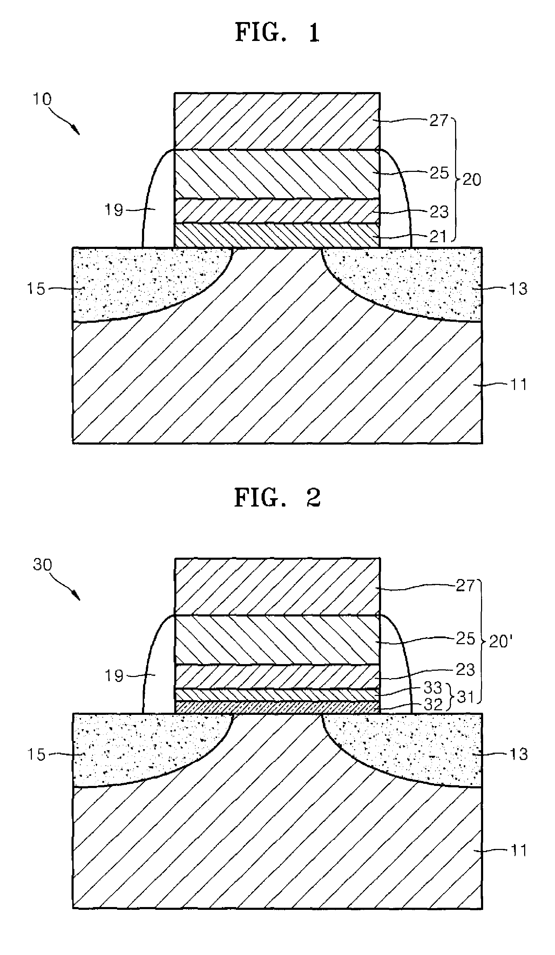

FIG. 1 is a schematic view of a charge trap memory device 10 according to example embodiments. The thicknesses of the layers and/or regions in FIG. 1 may have been exaggerated for clarity. Referring to FIG. 1, the charge trap memory device 10 may include a gate structure 20 formed on a substrate 11. First and second impurity regions 13 and 15 doped with conductive impurities may be formed in the substrate 11. One of the first and second impurity regions 13 and 15 may be a drain region (D), while the other may be a source region (S). In FIG. 1, reference number 19 denotes a spacer.

The gate structure 20 may include a charge trap layer 23. A tunnel insulating layer 21 may be formed between the substrate 11 and the charge trap layer 23. The tunnel insulating layer 21 may be formed on the substrate 11 to contact the first and second impurity regions 13 and 15. A blocking insulating layer 25 may be formed on the charge trap layer 23, and a gate electrode 27 may be formed on the blocking insulating layer 25. The tunnel insulating layer 21, the charge trap layer 23, the blocking insulating layer 25, and the gate electrode 27 may be sequentially stacked on the substrate 11.

The charge trap layer 23 may be formed of a higher-k dielectric insulating layer doped with one or more transition metals having a valence electron in a d-orbital.

The higher-k dielectric insulating layer may be formed of a compound selected from the group consisting of SiO₂, HfO₂, ZrO₂, Si₃N₄, Al₂O₃, HfSiON, HfON, and HfAlO and may have a permittivity of about 10 or more. The higher-k dielectric insulating layer may be used as a base matrix, because the higher-k dielectric insulating layer may increase programming efficiency and may include more charge traps at the same equivalence of thickness (EOT) than a conventional nitride layer used a charge trap layer.

When the higher-k dielectric insulating layer is doped with two or more different transition metals, electron traps and hole traps may be simultaneously formed in the higher-k dielectric insulating layer. A metal atom or oxygen atom of the molecular structure of the higher-k dielectric insulating layer may be substituted with a transition metal atom to form a stable trap. The transition metal may be a metal having a valence electron in a d-orbital. For example, a HfO₂ insulating layer may be doped with at least one transition metal selected from the group consisting of Ta, V, Ru, and Nb. The concentration of the doped transition metal may be about 0.01 - 15 % (atomic %).

When a HfO₂ layer is doped with a transition metal (e.g., Ta, V, Ru, Nb), the bonding of the electrons in the outermost shell of the transition metal atom to the electrons in the outermost shell of hafnium (Hf) atom may result in surplus electrons or holes. The surplus electrons or holes may function as hole traps or electron traps, respectively. The transition metal atom may replace a Hf atom or an oxygen (O) atom, or the transition metal atom may go into a unit cell of the HfO₂, or the transition metal atom may take a vacancy previously occupied by another atom. It may be beneficial to dope the HfO₂ layer with Ta, V, Ru, and/or Nb, because these transition metals may form a larger number of deeper traps in the HfO₂ layer. The stable energy level of a trap may be determined by quantum-mechanical calculation. Thus, the energy level of the trap may differ depending on the type of transition metal used.

When a Al₂O₃ layer is doped with a transition metal (e.g., W, Ru, Mo, Ni, Nb, V, Ti), the transition metal atom may replace a Al or an O atom, or the transition metal may form a bond with an existing atomic bond, or the transition metal may take a vacancy previously occupied by another atom. It may be beneficial to dope the Al₂O₃ layer with W, Ru, Mo, Ni, Nb, V, and/or Ti, because these transition metals may form a larger number of deeper traps in the Al₂O₃ layer. As noted above, the stable energy level of the trap may be determined by quantum-mechanical calculation. Thus, the energy level of the trap may differ depending on the type of transition metal used.

Further details relating to forming a charge trap layer formed of a higher-k dielectric insulating layer doped with a transition metal may be disclosed by commonly-owned U.S. Patent Application No. 11/723,081, filed on March 16, 2007, and corresponding Korean Patent Application No. 2006-0070886, filed on July 27, 2006, the entire contents of which are incorporated herein by reference.

The tunnel insulating layer 21 may be a single layer formed of silicon nitride (Si₃N₄). The impurity concentration of a silicon nitride layer may be about the same as or less than the impurity concentration of a silicon oxide layer that is used as a tunnel insulating layer in a conventional charge trap memory device. Also, the interface characteristic of a silicon nitride layer may be comparable to or better than a silicon oxide layer. The silicon nitride layer forming the tunnel insulating layer 21 may be formed using a special manufacturing method (e.g., jet vapor deposition method).

FIG. 2 is a schematic view of another charge trap memory device 30 according to example embodiments. In FIG. 2, the same reference numerals as shown in FIG. 1 denote the same elements. Consequently, a description of the above-discussed elements will not be repeated below. As in FIG. 1, the thicknesses of the layers and/or regions in FIG. 2 may have been exaggerated for clarity.

Referring to FIG. 2, in a charge trap memory device 30 according to example embodiments, a gate structure 20' may include a tunnel insulating layer 31 having a two-layered structure formed of a silicon nitride layer 33 and a silicon oxide layer 32. The silicon oxide layer 32, the silicon nitride layer 33, and the charge trap layer 23 may be sequentially stacked on a substrate 11.

The silicon oxide layer 32 may directly form an interface with the substrate 11, which may be formed of silicon, and the silicon nitride layer 33 may be grown using a general (as opposed to special) growth method. Thus, a silicon nitride layer 33 that is not formed using the above-mentioned special manufacturing method may also hinder the diffusion of metals from the charge trap layer 23 to the substrate 11 or the generation of metal-silicon compounds. Alternatively, the silicon nitride layer 33 may be formed using the above-mentioned special manufacturing method.

Because the tunnel insulating layer 21 or 31 and the charge trap layer 23 may have a higher permittivity than a conventional oxide layer, a blocking insulating layer 25 may be formed of a thinner layer having a higher permittivity and a larger band gap. For example, the blocking insulating layer 25 may be formed of Si₃N₄, HfO₂, Ta₂O₅, ZrO₂, or Al₂O₃. The gate electrode 27 may be formed of a metal layer having a larger work function. For example, the gate electrode 27 may be formed of gold, aluminum, and/or ruthenium (Ru). Also, the gate electrode 27 may be formed of TaN or a silicide (e.g., NiSi).

As described above, example embodiments provide a gate structure 20 and 20' of a charge trap memory device 10 and 30, wherein the charge trap layer 23 is formed of a higher-k dielectric thin layer doped with a transition metal. A silicon nitride layer may be used as a tunnel insulating layer 21 and 31 (tunneling barrier).
The tunnel insulating layer 21 and 31 may have a single-layered structure (e.g., without defects) or a two-layered structure formed of a silicon nitride layer 33 and a silicon oxide layer 32.

When a silicon nitride layer is used as the tunnel insulating layer 21 and 31, bonding between the metal doped in the charge trap layer 23 and silicon may be reduced, and the diffusion of the metal may be reduced or prevented, thereby reducing or preventing the generation of impurities in the tunneling insulating layer 21 and 31. Consequently, a charge leaking path, that may be generated when electric stress is externally applied, may also be blocked. Accordingly, charge retention characteristics of a memory device may be improved.

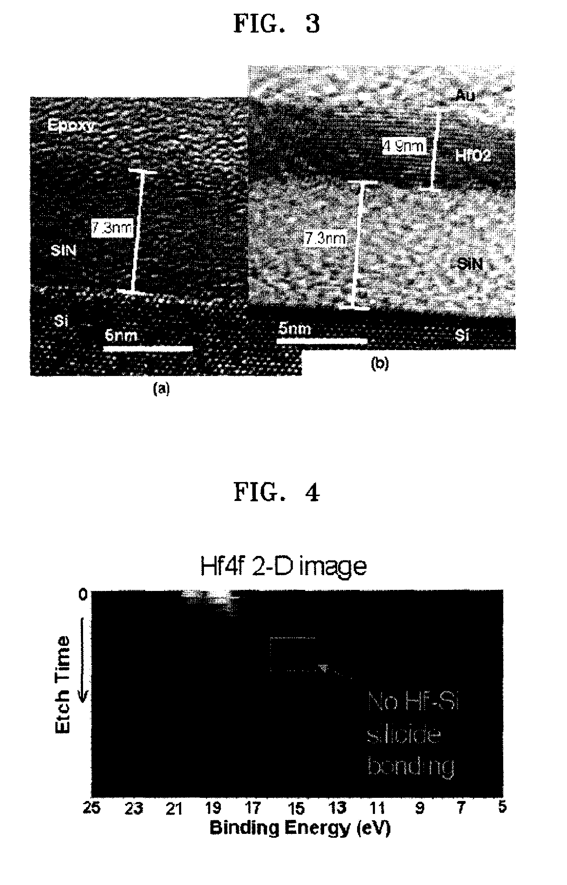

FIG. 3 is a transmission electron microscopy (TEM) photograph showing cross-sections of a silicon nitride layer and a higher-k dielectric insulating layer. FIG. 4 is an X-ray photoemission spectroscopy (XPS) depth profile showing that a metal-silicon bond is not present at an interface between the silicon nitride layer and the higher-k dielectric layer of FIG. 3. Referring to FIG. 3, case (a), wherein an epoxy layer is formed on a silicon nitride layer (SiN), is compared to case (b), wherein a HfO₂ layer, which is a higher-k dielectric insulating layer, is formed on a silicon nitride layer. As shown in FIG. 3, the thickness of the silicon nitride layer in case (b) has remained relatively unchanged with respect to case (a), thus showing that metal-silicon bonding at the interface between the silicon nitride layer and the HfO₂ layer has been reduced or prevented. The reduction or absence of metal-silicon bonding may also be shown in the XPS depth profile of FIG. 4.

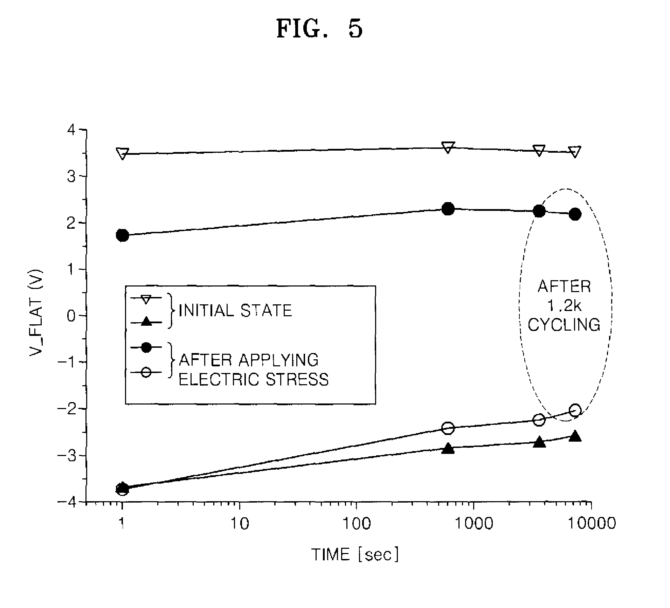

FIG. 5 shows the higher temperature retention characteristic obtained in a gate stack capacitor when a silicon nitride layer is used as a tunnel insulating layer. To obtain the result of FIG. 5, a charge trap memory device sample according to example embodiments was formed to have a gate structure of Al / Al₂O₃/ Ta+HfO₂ / Si₃N₄ / Si. In FIG. 5, the horizontal axis denotes time, and the vertical axis denotes flat band voltage (V-Flat). FIG. 5 shows the retention characteristic of the initial state of the sample when no electric stress is applied to the sample and the subsequent state when electric stresses are applied at about +18 V and about -18 V at about 1.2k cycling. The result of FIG. 5 was obtained by baking the sample at about 200 °C.

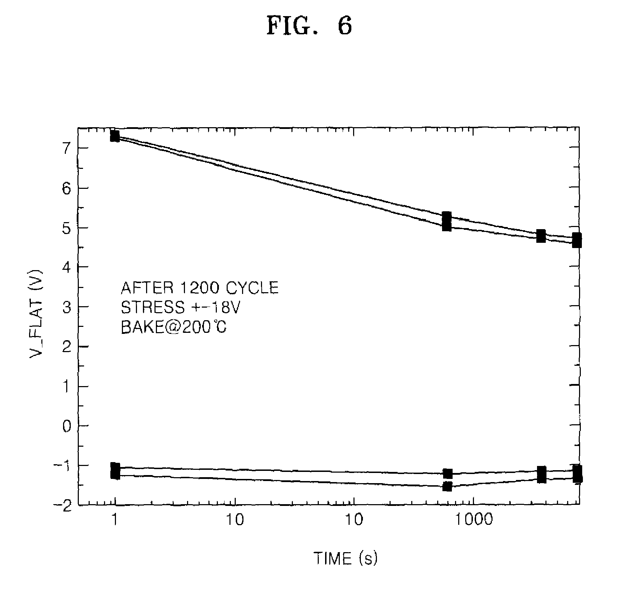

In contrast, FIG. 6 shows the higher temperature retention characteristic obtained in a gate stack capacitor when a silicon oxide layer is used as a tunnel insulating layer. To obtain the result of FIG. 6, a comparison charge trap memory device sample is formed to have a gate structure of Al / Al₂O₃/ Ta+HfO₂/ SiO₂/ Si. In FIG. 6, the horizontal axis denotes time, and the vertical axis denotes the flat band voltage (V-Flat). FIG. 6 shows the retention characteristic of the comparison sample when electric stresses are applied at about +18 V and about -18 V at about 1.2k cycling. The result of FIG. 6 was obtained by baking the comparison sample at about 200 °C.

The EOT of the gate structure the comparison sample was set to be about the same as the sample according to example embodiments. Consequently, the EOT of the silicon oxide layer of the comparison sample was set to be about the same as the silicon nitride layer of the sample according to example embodiments. The upper graphs in FIGS. 5 and 6 show the retention characteristic of electrons, while the lower graphs in FIGS. 5 and 6 show the retention characteristic of holes.

Comparing FIGS. 5 and 6, a tunnel insulating layer formed of a silicon oxide layer (as in the conventional art) shows a decreased retention of electrons when subjected to an electric stress of about 1.2 k cycling (FIG. 6). In contrast, as shown in FIG. 5, a tunnel insulating layer formed of a silicon nitride layer according to example embodiments shows an improved retention of electrons with respect to the comparison sample. Thus, the retention characteristic of electrons, which may be important in multi-level programming, may be improved.

As described above, a charge trap layer may be formed using a higher-k dielectric insulating layer doped with a transition metal. A tunnel insulating layer may be formed using a silicon nitride layer to reduce or prevent the formation of metal-silicon compounds or the diffusion of metals into a silicon channel region below. Thus, a more stable charge trap may be formed in the band gap of a charge trap layer, wherein charges may be trapped in the charge trap, thereby providing a charge trap non-volatile semiconductor memory device having improved retention characteristics.

While example embodiments have been disclosed herein, it should be understood that other variations may be possible. Such variations are not to be regarded as a departure from the scope of example embodiments of the present disclosure, and all such modifications as would be obvious to one skilled in the art are intended to be included within the scope of the following claims.

## Claims

1. A charge trap memory device comprising:
a tunnel insulating layer on a substrate; and
a charge trap layer on the tunnel insulating layer,
wherein the charge trap layer is a higher-k dielectric insulating layer doped with one or more transition metals, wherein the tunneling insulating layer does not react with the one or more transition metals in the charge trap layer or impedes diffusion of the one or more transition metals in the charge trap layer into the substrate.

2. The charge trap memory device of claim 1, wherein the tunnel insulating layer is made of silicon nitride.

3. The charge trap memory device of claim 1 or 2, wherein the higher-k dielectric insulating layer has a permittivity of about 10 or more.

4. The charge trap memory device of any preceding claim, wherein at least one of a metal atom and an oxygen atom in the higher-k dielectric insulating layer is substituted with a transition metal atom.

5. The charge trap memory device of any preceding claim, wherein at least one of the one or more transition metals has a valence electron in a d-orbital.

6. The charge trap memory device of any preceding claim, wherein the transition metal is selected from the group consisting of Ta, V, Ru, Nb, W, Mo, Ni, and Ti.

7. The charge trap memory device of any preceding claim, wherein the higher-k dielectric insulating layer is made of a compound selected from the group consisting of SiO₂, HfO₂, ZrO₂, Si₃N₄, Al₂O₃, HfSiON, HfON, and HfAlO.

8. The charge trap memory device of any of claims 1 to 6, wherein the higher-k dielectric insulating layer is a HfO₂ layer, and
the HfO₂ layer is doped with at least one transition metal selected from the group consisting of Ta, V, Ru, and Nb.

9. The charge trap memory device of any of claims 1 to 6, wherein the higher-k dielectric insulating layer is a Al₂O₃ layer, and
the Al₂O₃ layer is doped with at least one transition metal selected from the group consisting of W, Ru, Mo, Ni, Nb, V, and Ti.

10. The charge trap memory device of any preceding claim, wherein the one or more transition metals is doped to a concentration of about 0.01 - 15 atomic %.

11. The charge trap memory device of any preceding claim, wherein the one or more transition metals includes at least two different transition metals.

12. The charge trap memory device of any preceding claim, further comprising:
a blocking insulating layer on the charge trap layer; and
a gate electrode on the blocking insulating layer.

13. The charge trap memory device of claim 12, wherein the blocking insulating layer is made of a compound selected from the group consisting of Si₃N₄, HfO₂, Ta₂O₅, ZrO₂, and Al₂O₃.

14. The charge trap memory device of claim 12 or 13, wherein the gate electrode is made of gold, aluminum, ruthenium, or an alloy thereof.

15. The charge trap memory device of claim 12 or 13, wherein the gate electrode is made of TaN or silicide.

16. The charge trap memory device of any preceding claim, wherein the substrate includes a first impurity region and a second impurity region.

17. The charge trap memory device of any preceding claim, wherein the tunnel insulating layer has a two-layered structure, the tunnel insulating layer including a silicon nitride layer and a silicon oxide layer.

18. The charge trap memory device of claim 17, wherein the silicon nitride layer is on the silicon oxide layer.

19. The charge trap memory device of claim 18, further comprising:
a blocking insulating layer on the charge trap layer; and
a gate electrode on the blocking insulating layer.
